# DEMANDE DE BREVET EUROPEEN

(11) **EP 4 300 543 A1**
(43) Date de publication de la demande: **03.01.2024**
(21) Numéro de dépôt: 23182602.5
(22) Date de dépôt: 30.06.2023
(51) Int. Cl.: H01L 21/18, H01L 21/762

(54) **PROCÉDÉ DE FABRICATION D'UNE STRUCTURE PAVÉE**

(30) Priorité: 30.06.2022 FR 2206643
(71) Demandeur: COMMISSARIAT À L'ÉNERGIE ATOMIQUE ET AUX ÉNERGIES ALTERNATIVES, 75015 Paris (FR)
(72) Inventeur: MONTMEAT, Pierre, 38054 GRENOBLE Cedex 9 (FR); FOURNEL, Frank, 38054 GRENOBLE Cedex 9 (FR)
(74) Mandataire: Germain Maureau

(57) **Abrégé**

Procédé de fabrication d'une structure pavée (100) comprenant :
- a) fourniture d'une structure vignetée (50) comprenant un cadre rigide (4), des vignettes (1) collées de manière espacées sur le cadre rigide (4) pourvu d'un film adhésif (5) sensible aux UV,
- b) collage des vignettes (1) à un substrat support (S3) par l'intermédiaire d'une pâte à base minérale (6) de sorte à former un empilement (7),
- c) application d'une pression sur l'empilement (7) de sorte que la pâte à base minérale (6) remplisse l'espace (3) entre les vignettes (1),
- d) insolation du film adhésif (5) sensible aux UV,
- e) séparation du cadre rigide (4) et des vignettes (1) solidaires du substrat support (S3)), et
- f) application d'un traitement thermique de sorte transformer la pâte à base minérale (6) en un matériau minéral cohésif (6') pour obtenir la structure pavée (100).

## Description

La présente invention se rapporte au domaine du report de vignette en matériau semi-conducteur sur un substrat support. En particulier, la présente invention concerne un procédé de fabrication d'une structure pavée adaptée à des opérations ultérieures de fonctionnalisation comprenant notamment un transfert de film par des étapes d'implantation d'espèces ioniques, de collage et de fracture.

Un procédé de pavage d'un support par des vignettes est déjà connu dans l'art antérieur. Ce procédé consiste à fixer un substrat source sur un premier cadre rigide au moyen d'un premier ruban adhésif (également bien connu sous la terminologie anglo-saxonne `tape') sensible aux ultra-violets. Le substrat source est ensuite découpé en vignettes selon la géométrie désirée à l'aide d'une scie diamantée. Après insolation du premier ruban adhésif, les vignettes sont repositionnées sur un second cadre rigide pourvu d'un deuxième ruban adhésif sensible aux ultra-violets selon le positionnement souhaité. Puis la surface des vignettes est collée par collage direct sur la surface d'un substrat-poignée et le deuxième ruban est insolé pour séparer les vignettes du second cadre rigide. Après un recuit de consolidation du collage direct, les vignettes subissent des étapes technologiques comme par exemple des étapes de transfert de film mince prélevé sur la surface des vignettes sur un support receveur selon un procédé Smart Cut^{™}.

Toutefois, ce procédé de pavage connu implique de nombreux inconvénients. D'une part, la découpe des vignettes par une scie diamantée amène une importante contamination particulaire et métallique. D'autre part, l'utilisation d'un ruban adhésif amène une pollution organique qui est difficile à nettoyer avant de réaliser le premier collage direct. Il existe des solutions de nettoyage et de préparation de surface qui sont efficaces mais elles sont agressives et incompatibles avec la présence du ruban adhésif qui maintient les vignettes. Enfin, il est difficile de rectifier les différentes hauteurs des vignettes puis de polir leur surface car l'espace entre les vignettes conduit à une érosion plus importante des bords des vignettes, plus exposés à l'attaque du dispositif de polissage.

L'un des buts de la présente invention est de pallier au moins l'un de ces inconvénients. A cet effet, la présente invention propose un procédé de fabrication d'une structure pavée comprenant :
- a) fourniture d'une structure vignetée comprenant un cadre rigide, des vignettes collées de manière espacées sur le cadre rigide pourvu d'un film adhésif sensible aux UV, tel qu'un polymère acrylate,
- b) collage des vignettes à un substrat support par l'intermédiaire d'une pâte à base minérale de sorte à former un empilement,
- c) application d'une pression sur l'empilement de sorte que la pâte à base minérale remplisse l'espace entre les vignettes,
- d) insolation du film adhésif sensible aux UV,
- e) séparation du cadre rigide et des vignettes solidaires du substrat support, et
- f) application d'un traitement thermique de sorte à transformer la pâte à base minérale en un matériau minéral cohésif pour obtenir la structure pavée.

Le procédé de l'invention permet le report des vignettes sur un substrat support par collage via une pâte à base minérale. Ce collage est moins contraignant en terme de préparation de surface qu'un collage direct par adhésion moléculaire. Le traitement thermique selon l'étape f) permet la densification de la pâte à base minérale, l'élimination des éléments organiques et l'agrégation et/ou le frittage des grains de la poudre minérale constitutive de la pâte, comme on le verra en détail par la suite, pour conduire à l'obtention d'un matériau minéral cohésif. Ce matériau minéral cohésif présente une résistance mécanique et une force d'adhérence suffisante pour réaliser une opération éventuelle de rectification des vignettes en vue de former une surface plane de même qu'une éventuelle implantation d'espèces ioniques en vue de réaliser un transfert par Smart Cut^{™}.

L'application d'une pression sur l'empilement selon l'étape c) est réalisée de sorte que la pâte à base minérale remplisse l'espace entre les vignettes jusqu'à venir au contact du film adhésif sensible aux UV.

Par exemple, la pression appliquée sur l'empilement selon l'étape c) est de l'ordre d'une dizaine de kN, et notamment la pression est comprise entre 5 et 10 kN.

Concrètement, le traitement thermique de l'étape f) est réalisé par pallier.

Selon une possibilité, le traitement thermique de l'étape f) est réalisé à une température comprise entre la température ambiante et une température d'environ 450°C selon le(s) matériau(x) constitutifs des vignettes et de la pâte à base minérale utilisée pour l'obtention d'un matériau minéral cohésif. Par exemple pour une pâte à base minérale du type 'glass frit FX-11-036' de la société Ferro, la température est maintenue à 125°C pendant 30 min puis à 300°C pendant 60 min puis à 425°C pendant 90 min de sorte à obtenir le matériau minéral cohésif souhaité.

Selon une disposition, le procédé comprend après l'étape f) une étape g) de planarisation de la surface supérieure de l'ensemble des vignettes, de sorte que les vignettes forment collectivement une surface plane. La présence du matériau minéral cohésif facilite la rectification et le polissage car le bord des vignettes est moins exposé que lorsqu'elles sont collées par collage direct sans matériau de remplissage dans l'espace séparant les vignettes. De plus, l'obtention d'une telle surface plane facilite la réalisation d'étapes technologiques collectives, telle que des fonctionnalisations ou des reports de film mince.

En pratique, l'étape g) de planarisation est réalisée par rodage puis par polissage mécanochimique, de sorte à atteindre une rugosité de surface des vignettes compatible avec un collage direct, par exemple une rugosité de surface < 0,5 nm RMS mesurée par AFM sur un scan de 1*1µm².

Selon une possibilité, le procédé comprend après l'étape g) de planarisation, une étape h) d'une gravure chimique sélective de la face exposée de la structure pavée, de sorte à graver le matériau minéral cohésif plus rapidement que la surface exposée des vignettes.

L'attaque chimique est notamment réalisée par une solution aqueuse de HF à 10% vol. pendant une durée permettant d'obtenir un retrait de quelques dizaines de nanomètres du matériau minéral cohésif par rapport à la surface des vignettes.

Selon une possibilité, le procédé comprend avant l'étape a) :
- une étape i) de collage démontable entre un substrat source de vignettes et un substrat-poignée,
- une étape ii) de vignetage du substrat source collé au substrat-poignée, notamment réalisée par photolithographie et gravure, de sorte à singulariser les vignettes,
- une étape iii) de fixation des vignettes de façon espacée sur le cadre rigide pourvu du film adhésif sensible aux UV, et
- une étape iv) de démontage du substrat-poignée des vignettes, de sorte à obtenir la structure vignetée fournie à l'étape a).

Ces étapes de préparation de la structure vignetée sans utilisation de scie diamantée limitent la contamination particulaire et métalliques des vignettes.

Selon une possibilité, le collage démontable selon l'étape i) est obtenu par l'utilisation d'une couche adhésive et d'une couche démontable à l'interface de collage entre le substrat source et le substrat-poignée. En effet, la couche démontable limite l'énergie d'adhésion avec la couche adhésive de sorte à permettre le démontage de l'étape iv) à l'interface entre la couche démontable et la couche adhésive par l'insertion d'un coin à ladite interface.

De manière concrète, la couche démontable est réalisée en un matériau choisi parmi composé chloré, tel que le octadecyltrichlorosilane, et un polymère fluoré, tel que le Novec^{™} 2702 fourni par 3M^{™}, le Novec^{™} 1720 de 3M^{™}, le polymère fluoré Optool développé par Daikin^{®}, le perfluorodecyltrichlorosilane, ou le perfluorodecyldimethylchlorosilane.

Selon une caractéristique, la couche adhésive est réalisée en un matériau choisi parmi les polymères thermoplastiques, par exemple un BrewerBOND^{®} 305 fourni par la société Brewer Science.

De manière pratique, le matériau de la couche démontable est étalé sur la surface du substrat-poignée. Le nettoyage ultérieur de la couche démontable étant difficile, il est préférable de le placer sur le substrat-poignée et de placer la couche adhésive sur le substrat source.

L'étape iv) de démontage comprend également le retrait de la couche adhésive par nettoyage de la structure vignetée en utilisant notamment du D-limonène puis de l'isopropanol lorsque la couche adhésive est en BrewerBOND^{®} 305. Ces composants sont inertes vis-à-vis de la structure vignetée.

Selon une variante de réalisation de la structure vignetée fournie à l'étape a), le collage démontable selon l'étape i) est obtenu par l'utilisation d'un film sec adhésif, choisi parmi les polymères à base de silicone, notamment le SPIS DFTA23 disponible dans la gamme professionnelle de Shin-Etsu^{®}. Ce film sec adhésif est simple d'utilisation, il ne nécessite pas d'étalement par centrifugation ni d'étape de recuit. Il permet d'atteindre une énergie d'adhésion suffisante pour la réalisation du vignetage du substrat source sans interdire le démontage de l'étape iv) du substrat-poignée par insertion d'un coin à l'interface.

Une fois le substrat-poignée démonté, l'étape iv) du procédé comprend en outre le retrait par simple nettoyage du film adhésif sec de la surface des vignettes par une solution comprenant du p-menthol puis une solution comprenant de l'isopropanol. Cette solution est inerte vis-à-vis de la structure vignetée.

Selon une variante de réalisation de la structure vignetée, le procédé utilise une technologie de vignetage par traitement laser, qui consiste en une découpe par endommagement laser, bien connue selon la dénomination 'Stealth Dicing' (SD) et par exemple décrite dans les articles suivants : Masayoshi Kumagai et al, IEEE TRANSACTIONS ON SEMICONDUCTOR MANUFACTURING, VOL. 20, NO. 3, AUGUST 2007, Cereno, DI and Wickramanayaka, S, 2017 IEEE 67TH ELECTRONIC COMPONENTS AND TECHNOLOGY CONFERENCE (ECTC 2017), pp.358-363, et Gaudiuso, C; Volpe, A and Ancona, A, Mar 2020, MICROMACHINES 11.

Aussi, selon cette alternative, le procédé comprend avant l'étape a) :
- une étape j) de traitement laser d'un substrat source collé sur un cadre d'appui pourvu d'un ruban adhésif sensible aux UV de sorte à préformer des lignes de découpe au sein du substrat source, les lignes de découpe étant destinées à former les vignettes,
- une étape jj) d'extension du ruban adhésif de sorte à provoquer la rupture du substrat source selon les lignes de découpe préformées et former les vignettes, et
- une étape jjj) de fixation des vignettes sur le cadre rigide pourvu d'un film adhésif sensible aux UV, et
- une étape jjjj) de séparation du cadre d'appui et des vignettes comprenant l'insolation du ruban adhésif sensible aux UV, de sorte à obtenir la structure vignetée fournie à l'étape a).

Cette alternative évite l'utilisation d'étapes de photolithographie et de gravure dans le substrat source afin de fournir les vignettes.

Selon une possibilité, le cadre rigide et le film adhésif sensible aux UV respectivement utilisés à l'étape iii) ou à l'étape jjj) présentent un diamètre supérieur à celui du substrat source,
et le procédé comprend respectivement à l'étape iii) ou jjj) la fixation des vignettes en augmentant l'espace entre les vignettes, en modifiant la position initiale des vignettes et/ou en fixant des vignettes de plusieurs substrats sources sur un unique substrat support d'un diamètre supérieur à celui du substrat source.

Selon une possibilité, le procédé comprend en outre après l'étape f), et par exemple après l'étape g) ou h) :
- une étape k) d'implantation d'espèces ioniques dans les vignettes de la structure pavée de sorte à créer un plan de fragilisation dans chaque vignette délimitant un film mince entre la face implantée et ledit plan de fragilisation,
- une étape l) de collage moléculaire de la face implantée des vignettes sur un substrat receveur,
- une étape m) de fracture au niveau du plan de fragilisation, notamment par application d'un traitement thermique, de sorte à transférer collectivement le film mince de chaque vignette sur le substrat receveur.

Selon une disposition, les étapes k, l et m) sont répétées n fois sur le négatif obtenu à l'issue de l'étape m), le négatif comprenant le substrat support et les vignettes, de sorte à réaliser n nouveaux transferts collectifs du film mince de chaque vignette sur un support receveur.

Selon une autre possibilité, le procédé comprend après l'étape f), et par exemple après l'étape g) ou h) la réalisation d'étapes technologiques collectivement sur les vignettes de la structure pavée.

De manière pratique, la pâte à base minérale comprend une poudre minérale, un liant et un solvant d'homogénéisation.

Concrètement, la poudre minérale comprend des grains présentant une taille inférieure ou égale au dixième de l'espace inter puce entre les vignettes adjacentes de sorte à faciliter le comblement de l'espace inter puce lors de l'étape c). Cette limitation en taille permet de faciliter le remplissage des espaces inter puces avec la pâte à base minérale. Ensuite la densification /frittage obtenus par le traitement thermique selon l'étape f) permet de solidariser et de faire grossir ces grains conduisant à l'obtention du matériau minéral cohésif.

Selon d'autres caractéristiques, le procédé de fabrication d'une structure pavée comporte une ou plusieurs des caractéristiques optionnelles suivantes considérées seules ou en combinaison :
- La pâte à base minérale est étalée préalablement au collage de l'étape b) sur la face exposée des vignettes et/ou sur le substrat support.
- L'étape d) d'insolation est réalisée avant l'étape c) d'application d'une pression.
- L'étape d) d'insolation est réalisée après l'étape c) d'application d'une pression.
- La couche démontable et la couche adhésive formées selon l'étape i), sont recuites par application d'un traitement thermique.
- Le substrat source est formé par au moins un matériau constitutif des vignettes de la structure pavée et comprend au moins un matériau semi-conducteur, notamment choisis parmi la colonne IV et les colonnes III/V du tableau périodique des éléments.
- Les matériaux des vignettes sont choisis parmi les matériaux semiconducteurs, notamment choisis parmi la colonne IV et les colonnes III/V du tableau périodique des éléments et par exemple le silicium, le Ge, l'InP, l'AsGa, le SiC, le verre, l'alumine, la saphir, le LNO, le LTO et le quartz.
- Les vignettes de la structure pavée sont toutes constituées d'un même et unique matériau.
- La structure pavée comprend des vignettes de matériaux différents.
- Chacune des vignettes de la structure pavée est composée d'une structure composite, la structure composite comprenant des matériaux différents ou identiques.
- L'espace entre deux vignettes adjacentes de la structure vignetée est compris entre 100 et 200 micromètres.
- Chaque vignette présente une face principale de forme polygonale par exemple carrée ou rectangulaire ou une forme ovale ou circulaire.
- L'étape ii) comprend une étape de retrait des vignettes en bord du substrat-poignée dont la face principale présente une forme différente de celle de la majorité des vignettes.
- La pâte à base minérale est uniquement formée par une poudre minérale, un liant et un solvant d'homogénéisation
- La poudre minérale est choisie parmi les poudres métalliques, les poudres métalloïdes, les poudres céramiques et une combinaison de ces poudres, notamment des poudres métalloïdes ou céramiques de sorte à éviter une contamination métallique et par exemple une poudre d'une composition identique à celle des vignettes.
- Les poudres métalliques sont choisies parmi l'argent, cuivre, étain et le tungstène par exemple.
- Les poudres métalloïdes sont choisies parmi le silicium, germanium, et l'antimoine, par exemple.
- Les poudres céramiques sont choisies parmi les oxydes et les silicates, par exemple du SiO₂, GeO₂, Al₂O₃, TiOz, du mica, etc...
- La pâte à base minérale est composée de sorte à présenter les propriétés nécessaires pour pouvoir être étalée par sérigraphie ou par coulage en bande.
- La quantité de solvant d'homogénéisation est choisie de sorte que ladite pâte à base minérale présente une viscosité comprise entre 10 et 500Pa.s.
- Le solvant d'homogénéisation est notamment choisi parmi la N-méthyl-2-pyrrolidone, le terpinol, et le limonène.
- La nature du liant de la pâte à base minérale est choisie de sorte à conférer une cohésion à la pâte à base minérale.
- Le liant de la pâte à base minérale est choisi parmi les matériaux minéraux, les matériaux organiques et une combinaison de ces matériaux.
- Les matériaux minéraux formant le liant de la pâte à base minérale sont choisis parmi du verre dopé du type polysilicate alcalin Li₂Si₅O₁₁, un polyphosphate (NaPO₃)n, et un phosphate H₂LiPO₄.
- Les matériaux organiques formant le liant de la pâte à base minérale sont des matériaux polymères, tel que le polyfluorure de vinylidène, la polyvinylpyrrolidone, l'éthyle cellulose, ou le polyéthylène glycol.
- La pâte à base minérale est en composé 'glass frit FX-11-036' disponible auprès de la société Ferro.
- La pâte à base minérale est constituée par un mélange d'une poudre minérale de silice (Aerosil^{®} R202 - 5g) d'un liant d'éthyle cellulose (Sigma Aldrich^{®} - 0,5g) et d'un solvant d'homogénéisation en Terpinol (Sigma Aldrich^{®} - 5g).
- La répétition n fois des étapes k, l et m) sur le négatif obtenu à l'issue de l'étape m), comprend au préalable la réalisation de l'étape g) de planarisation de la surface supérieure de l'ensemble des vignettes, et/ou une étape h) d'attaque chimique sélective de la face exposée de la structure pavée, de sorte à retirer la zone écrouie par l'implantation d'espèces ioniques selon l'étape k) précédemment réalisée, et obtenir le retrait du matériau minéral cohésif issu de la pâte à base minérale par rapport à la surface des vignettes.
- Les étapes décrites ci-dessus sont répétées n fois jusqu'à ce que l'épaisseur résiduelle des vignettes ne soit plus suffisante pour effectuer un transfert collectif des films.
- Le cadre rigide est un cadre en métal, du type des cadres métalliques DISCO^{®}, ou un cadre rigide constitué de tout autre matériau non contaminant dans les conditions d'utilisation.
- Le substrat-poignée est en silicium.
- Le substrat support est en silicium.
- Le film et le ruban adhésifs sensibles aux UV sont en polymère acrylate notamment en composé 'SP-537T-230' disponible auprès de la société Furukawa Electric.

D'autres aspects, buts et avantages de la présente invention apparaîtront mieux à la lecture de la description suivante de différentes variantes de réalisation de celle-ci, données à titre d'exemple non limitatif et fait en référence aux dessins annexés. Les figures ne respectent pas nécessairement l'échelle de tous les éléments représentés de sorte à améliorer leur lisibilité. Des traits pointillés symbolisent un plan de fragilisation formé dans un substrat. Dans la suite de la description, par souci de simplification, des éléments identiques, similaires ou équivalents des différentes formes de réalisation portent les mêmes références numériques.
[Fig.1] est une vue schématique illustrant une étape i) et ii) du procédé selon un mode de réalisation de l'invention.
[Fig.2] est une vue schématique illustrant une étape iii) du procédé selon le mode de réalisation de la figure 1 et la fourniture de la structure vignetée a).
[Fig.3] est une vue schématique illustrant des étape b) à d) du procédé selon le mode de réalisation de la figure 1.
[Fig.4] est une vue schématique illustrant des étapes e) et f) du procédé le mode de réalisation de la figure 1.
[Fig.5] est une vue schématique illustrant des étapes g) et h) puis de l'étape k) d'implantation selon un mode de réalisation de l'invention.
[Fig.6] est une vue schématique illustrant des étapes l) et m) du procédé selon un mode de réalisation de l'invention.
[Fig.7] est une vue schématique illustrant une étape j) du procédé selon une possibilité de réalisation de l'invention.
[Fig.8] est une vue schématique illustrant les étapes jj) à jjjj) du procédé selon le mode de réalisation de la figure 7.
[Fig.9] est une vue schématique illustrant une étape jjj) ou iii) de report de vignettes de plusieurs substrats sources sur un unique cadre de plus grand diamètre selon une variante de réalisation de l'invention.

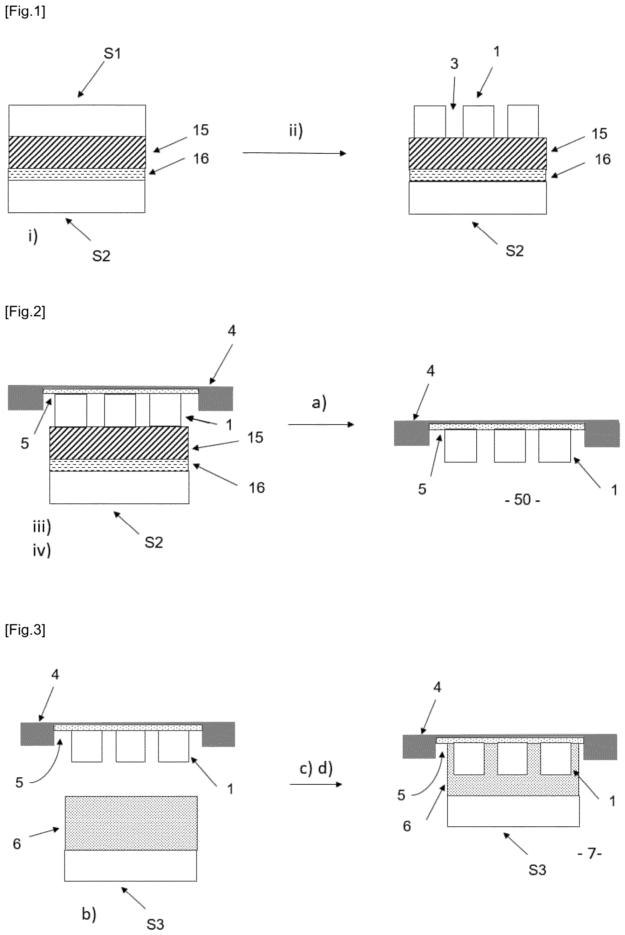

Comme illustré aux figures 1 à 6, le procédé selon l'invention comprend la préparation d'une structure vignetée 50, le report de vignettes 1 sur un substrat support S3 de sorte à obtenir une structure pavée 100, des étapes de fonctionnalisation des vignettes 1, et/ou de réalisation d'un transfert collectif d'un film mince 2 prélevé de chacune des vignettes 1 sur un substrat receveur S4.

Le procédé de fabrication d'une structure pavée 100 comprend tout d'abord une étape de collage démontable d'un substrat source S1 sur un substrat-poignée S2 (figure 1- étape i) suivie d'une étape de vignetage comprenant une photolithographie de la surface du substrat source S1 puis d'une gravure dans le substrat source S1 formant des tranchées 3 pour délimiter des vignettes 1 espacées (figure 1- étape ii). Un cadre rigide 4 pourvu d'un film adhésif 5 sensible aux UV est fourni pour y fixer les vignettes 1 (figure 2- étape iii). Le substrat-poignée S2 est ensuite démonté au niveau de l'interface de collage démontable de sorte à obtenir la structure vignetée 50 qui sera fournie à l'étape a) du procédé (figure 2 - étape iv).

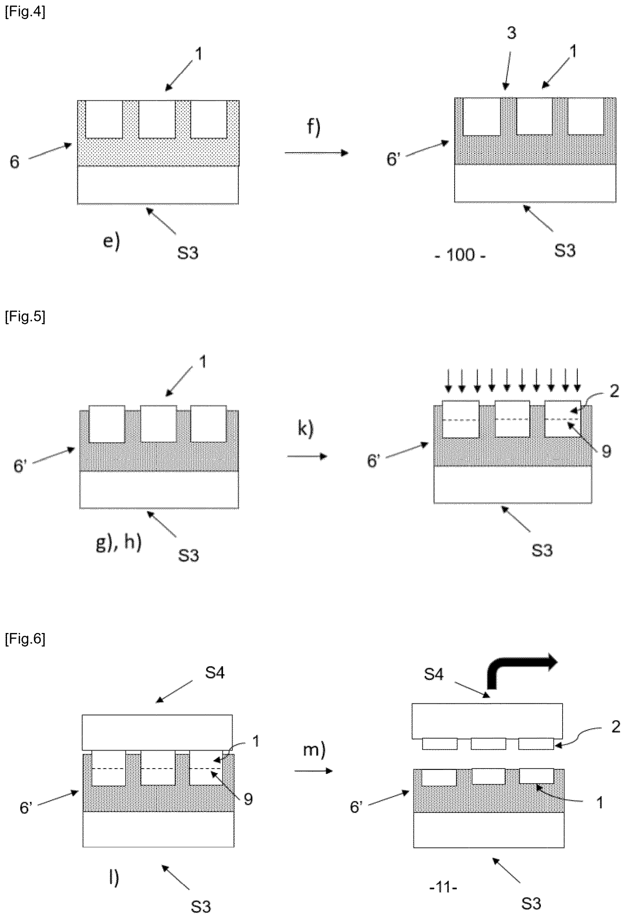

Les vignettes 1 sont ensuite collées sur un substrat support S3 recouvert d'une pâte à base minérale 6 pour former un empilement 7 (figure 3 ). Une pression est appliquée de part et d'autre de l'empilement 7 de sorte à assurer le comblement de l'espace 3 entre les vignettes 1 par la pâte à base minérale 6 (figure 3, étapes b et c). Une étape d) d'insolation du film adhésif 5 sensible aux UV est ensuite réalisée (figure 3) avant de séparer le cadre rigide 4 des vignettes 1 solidaires du substrat support S3, (figure 4 - étape e).

Un traitement thermique est appliqué pour :
- permettre l'élimination des composants organiques de la pâte à base minérale 6,
- densifier la pâte minérale 6 par agrégation et /ou frittage des grains minéraux.
En fin de traitment thermique, seul subsiste la partie minérale de la pâte 6' (figure 4, étape f). On obtient alors la structure pavée 100. Ce traitement thermique et cette structuration du matériau minéral cohésif 6' permettent aussi d'augmenter l'énergie d'adhérence des vignettes 1 sur le substrat support S3. Une étape g) de planarisation de la surface supérieure 8 de l'ensemble de vignettes 1 est ensuite effectuée afin que les vignettes 1 forment collectivement une surface plane (figure 5). Selon les matériaux utilisés et la méthode de planarisation effectuée, l'étape g) n'est pas suffisante pour obtenir un retrait du matériau minéral cohésif 6' par rapport à la surface des vignettes 1 (ou elle est volontairement limitée pour diminuer les coûts), ce qui risque de gêner un futur transfert collectif par Smart Cut^{™} des vignettes 1 sur un substrat receveur S4. Une étape h) de gravure chimique sélective est alors opérée de sorte à obtenir un retrait compris entre 10 et 20 nm du matériau minéral cohésif 6' dérivé de la pâte à base minérale 6 dans l'espace 3 entre les vignettes 1 (figure 5).

La structure pavée 100 ainsi préparée est avantageusement utilisée pour un transfert collectif de film mince 2 provenant des vignettes 1 sur un substrat receveur S4. Pour ce faire, une étape k) d'implantation d'espèces ioniques est réalisée dans les vignettes 1 de sorte à créer un plan de fragilisation 9 délimitant un film mince 2 dans chaque vignette 1, le film mince 2 étant compris entre la surface implantée et le plan de fragilisation 9 (figure 5). La structure pavée 100 implantée est alors utilisée pour un collage moléculaire sur un substrat receveur S4 selon l'étape l) du procédé (figure 6). Il s'ensuit une étape m) de fracture au niveau du plan de fragilisation 9 de sorte à transférer collectivement le film mince 2 de chaque vignette 1 sur le substrat receveur S4 et obtenir une nouvelle structure pavée par collage direct (figure 6). Le négatif 11 obtenu à l'issue de la fracture de la structure pavée 100 comprend le substrat support S3 et les vignettes 1 amincies. Ce négatif 11 est avantageusement réutilisé après planarisation, polissage etc... dans nouveau transfert collectif de film mince 2 des vignettes 1 sur un nouveau substrat receveur S4 (figure 5).

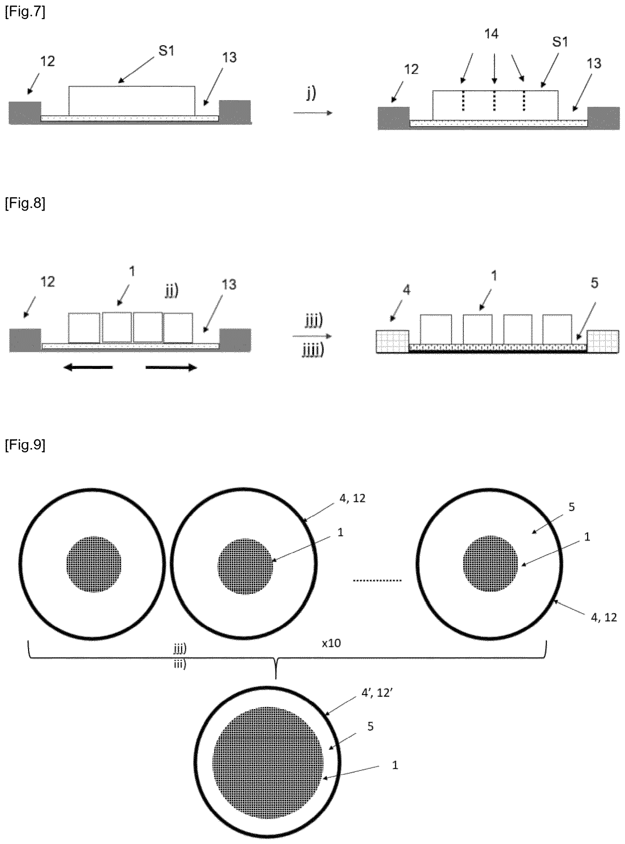

Une variante de réalisation du procédé selon l'invention diffère de celui décrit ci-dessus en ce que la structure vignetée 50 est préparée selon une technologie de 'stealth dicing' (figure 7). Cette variante comprend :
- une étape j) de traitement laser d'un substrat source S1 collé sur un cadre d'appui 12 pourvu d'un ruban adhésif 13 sensible aux UV, de sorte à préformer des lignes de découpe 14 au sein du substrat source S1, les lignes de découpe 14 étant destinées à former les vignettes 1 (figure 7),
- une étape jj) d'extension du ruban adhésif 13 de sorte à provoquer la rupture du substrat source S1 selon les lignes de découpe 14 préformées et former les vignettes 1, (figure 8),
- une étape jjj) de fixation des vignettes 1 sur un cadre rigide 4 pourvu d'un film adhésif 5 sensible aux UV, et une étape jjjj) de séparation du cadre d'appui 12 et de la pluralité des vignettes 1 comprenant l'insolation du ruban adhésif 13 sensible aux UV, (figure 8) de sorte à obtenir la structure vignetée 50 fournie à l'étape a).

Selon encore une autre variante de réalisation qui diffère du procédé décrit ci-dessus, le procédé comprend à l'étape iii) ou jjj) la fourniture respectivement d'un cadre d'appui 12 ou d'un cadre rigide 4 pourvu d'un film adhésif 5 sensible aux UV présentant un diamètre supérieur à celui du substrat source S1, par exemple de 300 nm et 100 nm respectivement, de sorte à fixer des vignettes 1 de plusieurs substrats sources S1 sur un même et unique cadre rigide 4' ou cadre d'appui 12' (figure 9). La fixation selon l'étape iii) ou jjj) est alors avantageusement réalisée par un dispositif de manipulation et de transfert de vignettes (Pick and Place) permettant la manipulation indépendante de chacune des vignettes 1 ou d'une pluralité de vignettes 1 en même temps. Les étapes suivantes sont réalisées comme précédemment décrit en utilisant un substrat support S3 et un substrat receveur S4 d'un diamètre au moins égal au diamètre du disque défini par les vignettes 1 sur le cadre rigide 4'/cadre d'appui 12' (non illustré).

Des exemples de réalisation détaillés du procédé selon l'invention suivent ci-dessous.

### Exemple 1

Une couche démontable 16 d'un polymère fluoré (Novec^{™} 2702) est formée par étalement sur un substrat-poignée S2 en silicium (200 mm de diamètre et de 725 µm d'épaisseur), et l'ensemble est recuit à 150°C pendant 30 min. L'épaisseur du film de polymère fluoré est de l'ordre de 10 nm.

Une couche adhésive 15 est formée en étalant 40 µm d'une résine adhésive BrewerBOND^{®} 305 sur un substrat source S1 en silicium (200 mm de diamètre et de 725 µm d'épaisseur) avant d'effectuer un collage avec le substrat-poignée S2 à 210°C de façon à obtenir un collage démontable à l'interface entre la couche adhésive 15 et la couche démontable 16 de polymère fluoré (figure 1- étape i).

Le substrat source S1 est aminci par abrasion mécanique au moyen d'une roue diamantée jusqu'à atteindre une épaisseur de 500 µm. La surface est ensuite nettoyée par voie humide. Une photo-lithogravure du substrat source S1 permet de définir des vignettes 1 de 8x8 mm² avec un espace 3 de 100 µm entre vignettes 1 adjacentes (figure 1, étape ii).

Les vignettes 1 ainsi obtenues présentent une épaisseur de 500 micromètres. Elles sont ensuite collées sur un cadre rigide 4 métallique DISCO^{®} au moyen d'un film adhésif 5 sensible aux UV 'SP-537T-230' disponible auprès de la société Furukawa (figure 2, étape iii). Le substrat-poignée S2 est ensuite détaché par l'insertion d'un coin à l'interface entre la couche adhésive 15 et la couche de démontage 16 (étape iv). La couche adhésive 15 est retirée par un nettoyage à base de D-limonène puis d'isopropanol. La structure vignetée 50 comprenant des vignettes 1 collées par un film adhésif 5 sur un cadre rigide 4 est ainsi obtenue (figure 2) et peut être fournie selon l'étape a) du procédé de l'invention.

Sur un substrat support S3 de silicium (200 mm de diamètre et de 725 µm d'épaisseur) est étalé par sérigraphie environ 100 µm de pâte à base minérale 6 « glass frit FX-11-036 » de la société Ferro. Le film adhésif 5 sensible aux UV de la structure vignetée 50 est insolé par irradiation UV (étape d) puis le substrat support S3 est mis en contact avec les vignettes 1 de sorte à former un empilement 7 (étape b) tout en appliquant une pression de 5 kN (figure 3, étape c). Selon une variante, il est possible d'insoler le film adhésif 5 sensible aux UV (étape d) après la mise en contact.

Le cadre rigide 4 est séparé de l'empilement 7 constitué du substrat support S3 et des vignettes 1 (figure 4, étape e). Un recuit par application d'un traitement thermique à 125°C pendant 30 min, puis 300°C pendant 60 min et 425°C pendant 90 min (figure 4, étape f) permet la transformation de la pâte à base minérale 6 en matériau minéral cohésif 6' et l'obtention de la structure pavée 100. Les vignettes 1 sont solidaires du substrat support S3 et l'espace 3 entre les vignettes 1 est comblé. La surface des vignettes 1 est planarisée par une étape de rodage mécanique puis une étape de polissage mécano-chimique approfondie (étape g). La vitesse de polissage du matériau minéral cohésif 6' issu du glass frit est supérieure à la vitesse de polissage du silicium, ce qui conduit à un retrait du matériau minéral cohésif 6' d'environ 20 nm par rapport à la surface des vignettes 1 en silicium (figure 5).

La structure pavée 100 ainsi préparée est soumise à une implantation d'ions hydrogène avec une énergie de 150 keV et une dose de 5.10¹⁶ ions/cm² (figure 5, étape k). Un substrat receveur S4 en silicium (200 mm de diamètre et de 725 µm d'épaisseur) est oxydé de façon à former un film de SiO₂ de 500 nm à sa surface (non représenté). Le substrat receveur S4 est ensuite préparé de façon à réaliser un collage direct avec la face implantée des vignettes 1 (figure 6, étape l). Un recuit à 500°C permet d'obtenir une fracture au niveau du plan de fragilisation 9 et un film mince 2 d'une épaisseur de 1,2 µm provenant de chacune des vignettes 1 est transféré sur le substrat receveur S4 (figure 6, étape m). Un polissage mécano-chimique du négatif 11 obtenu à l'issue de l'étape m) comprenant le substrat support S3 et les vignettes 1 permet une nouvelle utilisation dans un procédé de transfert de film mince 2 comme précédemment décrit selon les étapes k à m).

### Exemple 2

Une couche démontable 16 de 10 nm de polymère fluoré (Novec^{™} 1720) est formée par étalement sur un substrat-poignée S2 en silicium (200 mm de diamètre et de 725 µm d'épaisseur), et l'ensemble est recuit à 135°C pendant 15 min.

Une couche adhésive 15 est formée en étalant 40 µm d'une résine adhésive BrewerBOND^{®} 305 sur un substrat source S1 en silicium (200 mm de diamètre et de 725 µm d'épaisseur) avant d'effectuer un collage avec le substrat-poignée S2 à 210°C de façon à obtenir un collage démontable à l'interface entre la couche adhésive 15 et la couche 16 de polymère fluoré (figure 1, étape i).

Une photo lithogravure dans le silicium du substrat source S1 permet de définir des vignettes 1 de 20x20 mm² avec un espace 3 de 200 µm entre les vignettes 1 adjacentes (étape ii).

Les vignettes 1 ainsi obtenues sont collées sur un cadre métallique DISCO^{®} au moyen d'un film adhésif 5 'SP-537T-230' disponible auprès de la société Furukawa (étape iii). Le substrat-poignée S2 est ensuite détaché par l'insertion d'un coin à l'interface entre la couche adhésive 15 et la couche de démontage (figure 2, étape iv). La couche adhésive 15 est alors retirée par un nettoyage à base de D-limonène puis d'isopropanol de sorte à obtenir la structure vignetée 50.

Sur un substrat support S3 de silicium (200 mm de diamètre et de 725 µm d'épaisseur) est étalé par sérigraphie environ 100 µm de pâte à base minérale 6 « glass frit FX-11-036 » de la société Ferro (figure 3). Le film adhésif 5 sensible aux UV de la structure vignetée 50 est insolé par irradiation UV (étape d) puis les vignettes 1 en bord du cadre rigide 4 qui ne présentent pas la forme souhaitée (par exemple carrée) sont retirées au moyen d'un outil adapté de manipulation et de transfert de vignettes (Pick and Place).

Le substrat support S3 est ensuite mis en contact avec les vignettes 1 de sorte à former un empilement 7 (figure 3 étape b) tout en appliquant une pression de 5 kN (étape c).

Le cadre rigide 4 est séparé de l'empilement 7 constitué du substrat support S3 et des vignettes 1 (figure 4, étape e). Un recuit par application d'un traitement thermique à 125°C pendant 30 min, puis 300°C pendant 60 min et 425°C pendant 90 min (étape f) permet la transformation de la pâte à base minérale en matériau minéral cohésif 6' et l'obtention de la structure pavée 100. Les vignettes 1 sont solidaires du substrat support S3 et l'espace 3 entre les vignettes 1 est comblé. La surface des vignettes 1 est planarisée par une étape de rodage mécanique puis une étape de polissage mécano-chimique (figure 5, étape g) est appliquée de façon légère pour éviter une usure importante des consommables. Toutefois, le polissage léger ne permettant pas d'atteindre un retrait suffisant de matériau minéral cohésif 6', une attaque chimique sélective le complète avec une solution aqueuse de HF à 10% vol. pendant 1mn (étape h) et permet d'atteindre un retrait suffisant du matériau minéral cohésif 6' issu du « glass frit » par exemple 10 nm par rapport à la surface du silicium. La structure pavée 100 ainsi préparée peut être utilisée comme substrat donneur de film mince 2 de Si dans un procédé de transfert Smart Cut^{™} (implantation, collage, fracture).

### Exemple 3

La technologie de Stealth Dicing est utilisée pour découper dix substrats source S1 d'InP de 100mm de diamètre en puce de 10×10mm². Pour ce faire, les substrats sources S1 sont chacun disposés sur un ruban adhésif 13 sensible aux UV disposé sur un cadre d'appui 12. Une étape de traitement laser est effectuée dans chacun des substrats source de sorte à préformer des lignes de découpe 14 au sein du substrat source (étape j - figure 7). Le ruban adhésif 13 est ensuite étiré pour de sorte à provoquer la rupture du substrat source selon les lignes de découpe 14 préformées et former les vignettes 1 (figure 8, étape jj).

Un cadre rigide 4' d'une dimension adaptée à des plaques d'un diamètre de 300 mm et pourvu d'un film adhésif 5 sensible aux UV est utilisé pour reporter les vignettes 1 des dix substrats sources S1 (figure 9) à l'aide d'un outil adapté de manipulation et de transfert de vignettes (Pick and Place). Les vignettes 1 non carrées en bord de cadre ont été retirées au préalable (non illustré).

Sur un substrat support S3 de silicium (300 mm de diamètre et de 725 µm d'épaisseur) est étalé par sérigraphie environ 100 µm de pâte à base minérale 6 « glass frit FX-11-036 » de la société Ferro. Le substrat support S3 est mis en contact avec les vignettes 1 de sorte à former un empilement 7 (comme sur la figure 3, étape b) tout en appliquant une pression de 10 kN (étape c).

Le film adhésif 5 sensible aux UV 5 est insolé par UV et le cadre rigide 4 est séparé de l'empilement 7 constitué du substrat support S3 et des vignettes 1 (figure 4, étape e). Un recuit par application d'un traitement thermique à 125°C pendant 30 min, puis 300°C pendant 60 min et 350°C pendant 300 min (étape f) permet la transformation de la pâte à base minérale 6 en matériau minéral cohésif 6' et l'obtention de la structure pavée 100. Les vignettes 1 sont solidaires du substrat support S3 et l'espace 3 entre les vignettes 1 est comblé. La surface des vignettes 1 est planarisée par une étape de rodage mécanique puis une étape de polissage mécano-chimique léger (étape g).

Afin d'augmenter le retrait obtenu par le polissage mécano-chimique de l'étape g), il est complété par une attaque chimique sélective avec une solution aqueuse de HF à 10% vol. pendant 1mn (figure 5 - étape h). Ceci permet un retrait en matériau minéral cohésif 6' issu du « glass frit » d'environ 10nm par rapport à la surface de l'InP.

La structure pavée 100 ainsi préparée est soumise à une implantation d'ions hydrogène avec une énergie comprise entre 60 et 100 keV et une dose comprise entre 6 et 7.10¹⁶ ions/cm² en fonction de l'épaisseur de film d'InP à transférer (figure 6, étape k). Un substrat receveur S4 en silicium (300 mm de diamètre et de 725 µm d'épaisseur) est oxydé de façon à former un film de SiO₂ de 200 nm à sa surface. Le substrat receveur S4 est ensuite préparé de façon à réaliser un collage direct avec la face implantée des vignettes 1 (figure 6, étape l). Un recuit à 280°C permet d'obtenir une fracture au niveau du plan de fragilisation 9 et un film mince 2 provenant de chacune des vignettes 1 est transféré sur le substrat receveur S4 (étape m). Un polissage mécano-chimique du négatif 11 obtenu à l'issue de l'étape m) comprenant le substrat support S3 et les vignettes 1 permet une nouvelle utilisation dans un procédé de transfert de film mince 2 comme précédemment décrit selon les étapes k à m).

### Exemple 4 :

Un film sec adhésif en SPIS DFTA23 (Shin Etsu^{®}) est déposé par étalement sur un substrat-poignée S2 en silicium de 200 mm de diamètre (725 µm d'épaisseur),

Un collage démontable du substrat-poignée S2 avec un substrat source S1 de 200 mm de diamètre en germanium est réalisé à 90°C (figure 1, étape i). Une photo lithogravure du substrat source S1 en germanium permet de définir des vignettes 1 de 2x12 mm² avec un espace 3 entre les vignettes 1 adjacentes de 200 µm (étape ii).

Les vignettes 1 ainsi obtenues sont collées sur un cadre rigide 4 métallique DISCO^{®} au moyen d'un film adhésif 5 'SP-537T-230' disponible auprès de la société Furukawa (figure 2, étape iii). Le substrat-poignée S2 est ensuite détaché par l'insertion d'un coin à l'interface du collage démontable (figure 2, étape iv).

Le film sec adhésif en SPIS DFTA23 est alors retiré par un nettoyage à base de p-menthol puis d'isopropanol. La structure vignetée 50 comprenant des vignettes 1 collées par un film adhésif 5 en SP-537T-230 sur un cadre rigide 4 est ainsi obtenue. Ledit film adhésif 5 sensible aux UV est insolé par irradiation UV (figure 3, étape d).

Une pâte à base minérale 6 à base de silice est préparée en mélangeant 5 g de silice (Aerosil^{®} R 202) 0,5 g d'éthyle cellulose (Sigma-Aldrich^{®}) et 5 g de terpinol (Sigma-Aldrich^{®}). Environ 100 µm de cette pâte à base minérale 6 est étalée par sérigraphie sur un substrat support S3 de silicium (200 mm de diamètre et de 725 µm d'épaisseur) avant mise en contact avec les vignettes 1 de sorte à former un empilement 7 (figure 3, étape b) tout en appliquant une pression de 5 kN (étape c).

Le cadre rigide 4 est séparé de l'empilement 7 constitué du substrat support S3 et des vignettes 1 (figure 4, étape e). Un recuit par application d'un traitement thermique à 100°C pendant 60 min, puis 425°C pendant 120 min (étape f) permet la transformation de la pâte à base minérale 6 en matériau minéral cohésif 6' et l'obtention de la structure pavée 100. Les vignettes 1 sont solidaires du substrat support S3 et l'espace 3 entre les vignettes 1 est comblé. La surface des vignettes 1 est planarisée par une étape de rodage mécanique puis une étape de polissage mécano-chimique (étape g).

Après cette étape g) une attaque chimique sélective avec une solution aqueuse de HF à 10% vol. pendant 1min permet de mettre en retrait le matériau minéral cohésif 6' d'environ 10nm par rapport à la surface du silicium (figure 5, étape h). La structure pavée 100 ainsi préparée peut être utilisée comme substrat donneur de film mince 2 de Ge dans un procédé de transfert collectif par la technologie Smart Cut^{™} (implantation, collage et fracture).

### Exemple 5 :

On utilise des plaques de silicium de 200 mm de diamètre et de 725 µm d'épaisseur.

Une couche démontable 16 de polymère fluoré (Optool Daikin^{®}) est formée par étalement sur un substrat-poignée S2 en silicium (200 mm de diamètre et de 725 µm d'épaisseur) (figure 1).

Une couche adhésive 15 est formée en étalant 40 µm d'une résine adhésive BrewerBOND^{®} 305 sur un substrat source S1 en silicium (200 mm de diamètre et de 725 µm d'épaisseur) avant d'effectuer un collage avec le substrat-poignée S2 à 210°C de façon à obtenir un collage démontable à l'interface entre la couche adhésive 15 et la couche 16 de polymère fluoré (figure 1, étape i).

Une photo lithogravure dans le silicium du substrat source S1 permet de définir des vignettes 1 de 8x8 mm² avec un espace 3 de 100 µm entre les vignettes 1 adjacentes (étape ii).

Les vignettes 1 ainsi obtenues sont collées sur un cadre métallique DISCO^{®} au moyen d'un film adhésif 5 'SP-537T-230' disponible auprès de la société Furukawa (figure 2, étape iii). Le substrat-poignée S2 est ensuite détaché par l'insertion d'un coin à l'interface entre la couche adhésive 15 et la couche de démontage (étape iv). La couche adhésive 15 est retirée par un nettoyage à base de D-limonène puis d'isopropanol. La structure vignetée 50 comprenant des vignettes 1 collées par un film adhésif 5 sur un cadre rigide 4 est ainsi obtenue.

Sur un substrat support S3 de silicium (200 mm de diamètre et de 725 µm d'épaisseur) est étalé par sérigraphie environ 100 µm de pâte à base minérale 6 « glass frit FX-11-036 » de la société Ferro. Le film adhésif 5 sensible aux UV de la structure vignetée 50 est insolé par irradiation UV (figure 3, étape d) puis le substrat support S3 est mis en contact avec les vignettes 1 de sorte à former un empilement 7 (étape b) tout en appliquant une pression de 5 kN (étape c).

Le cadre rigide 4 est séparé de l'empilement 7 constitué du substrat support S3 et des vignettes 1 du fait de l'insolation préalable du film 5 (figure 4, étape e). Un recuit par application d'un traitement thermique à 125°C pendant 30 min, puis 300°C pendant 60 min et 425°C pendant 90 min (étape f) permet la transformation de la pâte à base minérale 6 en matériau minéral cohésif 6' et l'obtention de la structure pavée 100. Les vignettes 1 sont solidaires du substrat support S3 et l'espace 3 entre les vignettes 1 est comblé. La surface des vignettes 1 est planarisée par une étape de rodage mécanique puis une étape de polissage mécano-chimique (figure 5, étape g). La vitesse de polissage du matériau minéral cohésif 6' issu du glass frit est supérieure à la vitesse de polissage du silicium, ce qui conduit à un retrait du matériau minéral cohésif 6' d'environ 20 nm par rapport à la surface des vignettes 1 en silicium (pas de réalisation de l'étape h) dans cet exemple).

La structure pavée 100 ainsi préparée peut être utilisée comme substrat donneur de film mince 2 de Si dans un procédé de transfert Smart Cut^{™} (implantation, collage, fracture) comme décrit ci-dessus.
Ainsi la présente invention propose un procédé de fabrication d'une structure pavée 100 comprenant des vignettes en matériau semi-conducteur et configurée pour être utiliseé comme substrat donneur et transférer collectivement le film mince de chaque vignette sur un substrat receveur par Smart Cut^{™}, tout en limitant le nombre d'étapes de nettoyage des surfaces ainsi que le temps de cycle.

## Revendications

1. Procédé de fabrication d'une structure pavée (100) comprenant :
- a) fourniture d'une structure vignetée (50) comprenant un cadre rigide (4), des vignettes (1) collées de manière espacées sur le cadre rigide (4) pourvu d'un film adhésif (5) sensible aux UV,
- b) collage des vignettes (1) à un substrat support (S3) par l'intermédiaire d'une pâte à base minérale (6) de sorte à former un empilement (7),
- c) application d'une pression sur l'empilement (7) de sorte que la pâte à base minérale (6) remplisse l'espace (3) entre les vignettes (1),
- d) insolation du film adhésif (5) sensible aux UV,
- e) séparation du cadre rigide (4) et des vignettes (1) solidaires du substrat support (S3), et
- f) application d'un traitement thermique de sorte transformer la pâte à base minérale (6) en un matériau minéral cohésif (6') pour obtenir la structure pavée (100).

2. Procédé de fabrication d'une structure pavée (100) selon la revendication 1, comprenant après l'étape f) une étape g) de planarisation de la surface supérieure (8) de l'ensemble des vignettes (1), de sorte que les vignettes (1) forment collectivement une surface plane.

3. Procédé de fabrication d'une structure pavée (100) selon la revendication 2, comprenant après l'étape g) de planarisation, une étape h) d'une gravure chimique sélective de la face exposée de la structure pavée (100), de sorte à graver le matériau minéral cohésif (6') plus rapidement que la surface exposée des vignettes (1).

4. Procédé de fabrication d'une structure pavée (100) selon l'une des revendications 1 à 3, comprenant avant l'étape a) :
- une étape i) de collage démontable entre un substrat source (S1) de vignettes (1) et un substrat-poignée (S2),
- une étape ii) de vignetage du substrat source (S1) collé au substrat-poignée (S2), de sorte à singulariser les vignettes (1),
- une étape iii) de fixation des vignettes (1) de façon espacée sur le cadre rigide (4) pourvu du film adhésif (5) sensible aux UV, et
- une étape iv) de démontage du substrat-poignée (S2) des vignettes (1),de sorte à obtenir la structure vignetée (50) fournie à l'étape a).

5. Procédé de fabrication d'une structure pavée (100) selon l'une des revendications 1 à 3, comprenant avant l'étape a) :
- une étape j) de traitement laser d'un substrat source (S1) collé sur un cadre d'appui (12) pourvu d'un ruban adhésif (13) sensible aux UV de sorte à préformer des lignes de découpe (14) au sein du substrat source (S1), les lignes de découpe (14) étant destinées à former les vignettes (1),
- une étape jj) d'extension du ruban adhésif (13) de sorte à provoquer la rupture du substrat source (S1) selon les lignes de découpe (14) préformées et former les vignettes (1), et
- une étape jjj) de fixation des vignettes (1) sur le cadre rigide (4) pourvu d'un film adhésif (5) sensible aux UV, et
- une étape jjjj) de séparation du cadre d'appui (12) et des vignettes (1) comprenant l'insolation du ruban adhésif (13) sensible aux UV, de sorte à obtenir la structure vignetée (50) fournie à l'étape a).

6. Procédé de fabrication d'une structure pavée (100) selon l'une des revendications 4 ou 5, dans lequel le cadre rigide (4') et le film adhésif (5) sensible aux UV respectivement utilisés à l'étape iii) ou à l'étape jjj) présentent un diamètre supérieur à celui du substrat source (S1),
et dans lequel l'étape iii) ou l'étape jjj) comprend la fixation de vignettes (1) en augmentant l'espace (3) entre les vignettes (1), en modifiant la position initiale des vignettes (1) et/ou en fixant des vignettes (1) de plusieurs substrats sources (S1) sur un unique cadre rigide (4') d'un diamètre supérieur à celui du substrat source (S1).

7. Procédé de fabrication d'une structure pavée (100) selon l'une des revendications 1 à 6, comprenant en outre après l'étape f) :
- une étape k) d'implantation d'espèces ioniques dans les vignettes (1) de la structure pavée (100) de sorte à créer un plan de fragilisation (9) dans chaque vignette (1) délimitant un film mince (2) entre la face implantée et ledit plan de fragilisation (9),
- une étape l) de collage moléculaire de la face implantée des vignettes (1) sur un substrat receveur (S4),
- une étape m) de fracture au niveau du plan de fragilisation (9), de sorte à transférer collectivement le film mince (2) de chaque vignette (1) sur le substrat receveur (S4) et obtenir un négatif comprenant le substrat support et les vignettes (1) .

8. Procédé de fabrication d'une structure pavée (100) selon la revendication 7, dans lequel les étapes k, l et m) sont répétées n fois sur le négatif obtenu à l'issue de l'étape m), le négatif comprenant le substrat support et les vignettes (1), de sorte à réaliser n nouveaux transferts collectifs du film mince de chaque vignette (1) sur un support receveur (S4).

9. Procédé de fabrication d'une structure pavée (100) selon l'une des revendications 1 à 8, dans lequel la pâte à base minérale (6) comprend une poudre minérale, un liant et un solvant d'homogénéisation.

10. Procédé de fabrication d'une structure pavée (100) selon la revendication 9, dans lequel la poudre minérale comprend des grains présentant une taille inférieure ou égale au dixième de l'espace inter puce (3) entre les vignettes (1) adjacentes de sorte à faciliter le comblement de l'espace inter puce (3) lors de l'étape c).
